# EUROPEAN PATENT APPLICATION

(11) **EP 4 600 747 A1**
(43) Date of publication of application: **13.08.2025**
(21) Application number: 24157111.6
(22) Date of filing: 12.02.2024
(51) Int. Cl.: G03F 7/20, G03F 9/00, G01B 11/02

(54) **APPARATUS WITH A PLURALITY OF BEAM-MODIFYING MODULES FOR USE IN A METROLOGY TOOL**

(71) Applicant: ASML Netherlands B.V., 5500 AH Veldhoven (NL)
(72) Inventor: EURLINGS, Markus, Franciscus, Antonius, 5500 AH Veldhoven (NL); VAN PUTTEN, Eibert, Gerjan, 5500 AH Veldhoven (NL); WARNAAR, Patrick, 5500 AH Veldhoven (NL); ZHOU, Zili, 5500 AH Veldhoven (NL); MATHIJSSEN, Simon, Gijsbert, Josephus, 5500 AH Veldhoven (NL); NOOT, Marc, Johannes, 5500 AH Veldhoven (NL); MC NAMARA, Elliott, Gerard, 5500 AH Veldhoven (NL); DEN BOEF, Arie, Jeffrey, 5500 AH Veldhoven (NL)
(74) Representative: ASML Netherlands B.V.

(57) **Abstract**

An apparatus for use in a metrology apparatus comprises: selection optics; and a plurality of beam-modifying modules. The selection optics is arranged to receive an input radiation beam and is configurable so as direct the radiation beam to any one of the plurality of beam-modifying modules. Each of the plurality of beam-modifying modules is arranged to control the same at least one attribute of the radiation beam (for example wavelength, polarization, size, shape etc.). The selection optics may be arranged to receive secondary radiation output by any one of the plurality of beam-modifying modules and may be configurable so as direct the secondary radiation received from any one of the plurality of beam-modifying modules to a common output. A timescale for switching between two configurations of any one of the beam-modifying module may be larger than a timescale for switching between two configurations of the selection optics.

## Description

### FIELD

The present invention relates to a new apparatus for use in a metrology apparatus. For example, apparatus may form part of a metrology tool or a lithographic tool. The present invention also relates to a metrology tool comprising the new apparatus. The present invention also relates to a metrology method for determining one or more parameters of interest of a structure on an object (for example a silicon wafer).

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

It may be desirable to provide new metrology apparatus and methods for determining one or more parameters of a periodic target (for example on a wafer) that at least partially addresses one or more problems associated with known arrangements, whether such problems are identified herein or otherwise.

### SUMMARY

According to a first aspect of the present disclosure there is provided an apparatus for use in a metrology apparatus, the apparatus comprising: selection optics; and a plurality of beam-modifying modules; wherein the selection optics is arranged to receive an input radiation beam and is configurable so as direct the radiation beam to any one of the plurality of beam-modifying modules; and wherein each of the plurality of beam-modifying modules is arranged to control the same at least one attribute of the radiation beam.

In an alternative aspect, the selection optics is configurable so as direct the radiation beam to any one of the plurality of beam-modifying modules and/or receive the radiation beam from any one of the plurality of beam-modifying modules.

The apparatus according to the first aspect is advantageous, as now discussed.

Metrology apparatus may be used to inspect or qualify objects. For example, a metrology apparatus may be used to measure overlay of silicon wafers (i.e. how misaligned two subsequently formed lithographic layers are). It is desirable to make such measurements a plurality of times with different radiation beam attributes. Therefore, within a metrology apparatus there is often a beam-modifying modules that can control one or more attribute of the radiation beam (for example, wavelength, beam size, beam shape, polarization). An example, of a beam-modifying module is a colour selection module that can be used to control the wavelength of the output radiation beam.

Between two successive measurements made while using a given beam-modifying module, that beam-modifying module may be re-configured to as to modify one or more attribute of the radiation beam (so that the two successive measurements can be made using radiation with different attributes).

Advantageously, by providing a plurality of beam-modifying modules and selection optics that is configurable so as direct radiation to any one of the plurality of two beam-modifying modules, a throughput of the apparatus can be improved. For example, during one measurement using a first one of the plurality of beam-modifying modules, a second one of the plurality of beam-modifying modules can be configured ready for the next measurement. This avoids the need to wait for the time required to re-configure the beam-modifying module in between two successive measurements.

Furthermore, the selection optics may comprise relatively small and relatively simple optics. For example, the selection optics may comprise one or more fast mirrors. Therefore, the time scale required to switch from one of the beam-modifying modules to another of the beam-modifying modules can be significantly smaller than a typical time scale for re-configuring a beam-modifying module so as to modify one or more attribute of the radiation beam.

Furthermore, by providing a plurality of beam-modifying modules a significantly larger range of beam attribute values can be made available as compared to known arrangements.

As used herein, the term "attribute of a radiation beam" may be synonymous with the term "characteristic of a radiation beam".

The selection optics may be configurable in a finite number of discrete configurations, each such discrete configuration corresponding to a different one of the beam-modifying modules.

That is, the selection optics may comprise one or more optical elements that act as a fast switch with 2, 3, ..., n different configurations.

The selection optics may comprise one or more optical elements that are configurable in a plurality of different configurations.

For example, such an optical element that is configurable in a plurality of different configurations may comprise an optical element that is movable (e.g. relative to the radiation) such that it can be disposed in a plurality of different positions or orientations. Such optical elements may comprise reflective optical elements. Examples of suitable reflective optical elements include, for example, mirrors and prisms (for example used so as to achieve total internal reflection). Additionally or alternatively, such optical elements may comprise deflective optical elements. Examples of suitable deflective optical elements include, for example, refractive elements such as prisms arranged for the radiation beam to pass through (i.e. not used to achieve total internal reflection).

Additionally or alternatively, such an optical element that is configurable in a plurality of different configurations may comprise an acousto-optical deflector, elctro-optics or the like and which is arranged to deflect the radiation in a controllable manner.

The selection optics may comprise one or more movable optical elements.

For embodiments wherein the selection optics comprises a plurality of movable optical elements, the plurality of movable optical elements may share a common support. For embodiments wherein the selection optics comprises a plurality of movable optical elements, the plurality of movable optical elements may share a common movement mechanism.

At least one of the one or more movable optical elements may comprise a reflective optical element.

A reflective optical element is intended to mean any element comprising a reflective surface. Such reflective optical elements include, for example, mirrors and prisms.

Additionally or alternatively, at least one of the one or more movable optical elements may comprise a deflective optical element. Examples of suitable deflective optical elements include, for example, refractive elements such as prisms arranged for the radiation beam to pass through (i.e. not used to achieve total internal reflection).

The selection optics may be arranged to receive secondary radiation output by any one of the plurality of beam-modifying modules and may be configurable so as direct the secondary radiation received from any one of the plurality of beam-modifying modules to a common output.

That is, the selection optics may be configurable so as to direct secondary radiation to the common output regardless of the beam-modifying module from which it was received. The selection optics may be configurable so as direct the secondary radiation received from any one of the plurality of beam-modifying modules to the common output along a common trajectory.

The selection optics may be configurable in any one of a plurality of configurations, each one corresponding to a different one of the plurality of beam-modifying modules. The selection optics may comprise input optics and output optics. When configured in a configuration corresponding to a first one of the beam-modifying modules, input optics may be configured so as direct the radiation beam to the first beam-modifying module and output optics may be configured so as direct the secondary radiation from the first beam-modifying module to the common output.

The selection optics may comprise: (a) input optics disposed optically upstream of the plurality of beam-modifying modules, a configuration of which may determine which of the plurality of beam-modifying modules the radiation beam is directed to; and (b) output optics disposed optically downstream of the beam-modifying modules, a configuration of which may determine where secondary radiation output by one of the plurality of beam-modifying modules is directed to.

The input optics may comprise one or more optical elements that are configurable in a plurality of different configurations. The output optics may comprise one or more optical elements that are configurable in a plurality of different configurations.

The input optics may comprise at least one movable optical element. The output optics may comprise at least one movable optical element.

It will be appreciated that a first element being optically upstream of a second element is intended to mean that radiation (originating from the radiation beam) is incident on the first element before the second element. Similarly, it will be appreciated that a first element being optically downstream of a second element is intended to mean that radiation (originating from the radiation beam) is incident on the second element before the first element.

For such embodiments, a configuration of the selection optics may refer to both a configuration (for example orientation and/or position) of the input optics and a configuration (for example orientation and/or position) of the output optics.

The input optics and the output optics may share a common support.

Advantageously, this may allow for both of the input optics and the output optics to be controlled by a common movement mechanism and/or may help to synchronize movement of the input optics and the output optics. The input optics and/or output optics may each be movable relative to the common support.

The input optics and the output optics may share a movement mechanism.

Advantageously, this may help to synchronize movement of the input optics and the output optics as a single mechanism is responsible for moving both.

The apparatus may further comprise focusing optics arranged to focus the radiation beam in the vicinity of one or more configurable or movable optical elements of the selection optics.

Such an arrangement reduces a size of the radiation beam in the vicinity of the one or more configurable or movable optical elements of the selection optics. Advantageously, this allows for the size of these configurable or movable optical elements to be reduced and, in turn, allows these configurable or movable optical elements to be moved or re-configured faster. The one or more configurable or movable optical elements of the selection optics may comprise the input optics and/or the output optics.

The apparatus may further comprise focusing optics downstream of each configurable or movable optical element of the selection optics that is arranged to decrease a divergence of the radiation.

For example, the focusing optics downstream of the configurable or movable optical elements may be arranged to collimate the radiation. Additionally or alternatively, the focusing optics downstream of the configurable or movable optical elements may be arranged to focus the radiation in the vicinity of the beam-modifying modules.

A timescale for switching between two configurations of the selection optics may be of the order of 2 ms or less.

In some embodiments, a timescale for switching between two configurations of the selection optics is of the order of 1.5 ms or less. In some embodiments, a timescale for switching between two configurations of the selection optics is of the order of 1 ms or less.

The apparatus may further comprise a controller operable to control the selection optics; and/or the plurality of beam-modifying modules.

For example, the controller may be operable to re-configure the selection optics and/or the beam-modifying optics.

Each of the plurality of beam-modifying modules may be configurable in any one of a plurality of different configurations and the at least one attribute of the radiation beam may be different for each of the plurality of different configurations.

For example, each of the beam-modifying modules may comprise a colour selection module that can be used to control the wavelength spectrum (for example central wavelength and/or bandwidth) of the output radiation beam by control of the configuration of that colour selection module.

A timescale for switching between two configurations of any one of the beam-modifying modules may be larger than a timescale for switching between two configurations of the selection optics.

For example, in some embodiments, a timescale for switching between two configurations of any one of the beam-modifying modules is of the order of 10 ms to 100 ms or more whereas a timescale for switching between two configurations of the selection optics is of the order of 1 ms.

A timescale for switching between two configurations of any one of the beam-modifying module may be of the order of 5 ms or more.

For example, in some embodiments, a timescale for switching between two configurations of any one of the beam-modifying module is of the order of 10 ms to 100 ms or more.

Each of the plurality of beam-modifying modules may be arranged to control a spectrum of the radiation beam.

As used here, control of the spectrum of a radiation beam may include control of a central wavelength, a bandwidth and/or a shape of the spectrum of the radiation beam. For example, each of the plurality of beam-modifying modules may comprise a colour wheel or the like.

Each of the plurality of beam-modifying modules may be arranged to control a polarization state of the radiation beam.

Each of the plurality of beam-modifying modules may be arranged to control a size and/or shape of the radiation beam.

As will be apparent to the skilled person, in general, the size and/or shape of a radiation beam will vary as it propagates through an optical system (such as, for example, a metrology tool). It may, for example, refer to control of the size and/or shape of a radiation beam in a plane that is substantially perpendicular to a propagation direction of the radiation beam at any point along an optical axis of the apparatus. In particular, each of the plurality of beam-modifying modules may be arranged to control a size and/or shape of the radiation beam in any plane as desired or required. It will be appreciated that, in general, the radiation beam may not have a sharp edge (i.e. it may be that the intensity distribution is not described by a step function at the edge of the radiation beam). Rather, more realistically, at the "edges" of the radiation beam the spatial intensity distribution may fall to zero (or a negligible value) over an edge region having a non-zero size. The "shape" of the radiation beam may be defined as the shape of a region in which the intensity of the radiation beam is above a threshold value (which may be some small percentage of an intensity in a central portion of the radiation beam). Additionally or alternatively, the "shape" of the radiation beam may also describe how the intensity of the radiation beam falls off over the edge region. This may be described as an edge profile. As used herein the "shape" of the radiation beam is intended to mean any aspect of the spatial intensity distribution of the radiation beam. When the apparatus forms part of a metrology apparatus, the plane may be a pupil plane or a field plane of the metrology apparatus or an intermediate plane. In some embodiments, the plane may be a plane that is close to a pupil plane of the metrology apparatus (and may be referred to as a "pupil-like plane") or a plane that is close to a field plane of the metrology apparatus (and may be referred to as a "field-like plane").

According to a second aspect of the present disclosure there is provided a metrology tool for determining one or more parameters of interest of a structure on an object, the metrology tool comprising the apparatus according to the first aspect of the present disclosure.

When performing lithographic processes it is desirable to make frequent measurements of the structures created, for example, for process control and verification. Tools to make such measurements are typically called metrology tools. For example, some metrology tools make overlay measurements, which exploit the fact that the diffraction efficiencies of periodic structures are dependent on the unit cell of the periodic structure (and, therefore, any asymmetry of the unit cell). The response of such measurements is sensitive to the wavelength of radiation used by the scatterometer. Furthermore, it is desirable to separate out any imbalance in the relative intensities of certain diffraction orders that is due to overlay errors and other sources of such imbalances. For this reason, these scatterometry metrology tools often make a plurality of separate, sequential measurements of each metrology mark with different wavelengths of radiation, which are then combined. The specific wavelengths (and bandwidths) are typically dependent on the specific lithographic process or recipe and are typically optimized for a given process so as to maximize the response to overlay errors.

The metrology tool may further comprise: projection optics arranged to project radiation output by the apparatus according to the first aspect of the present disclosure onto a beam spot region in which the structure is positionable; detection optics arranged to receive at least a portion of radiation scattered by the structure; and a detector operable to determine one or more parameters from the received scattered radiation.

Each of the plurality of beam-modifying modules may be arranged to control a size and/or shape of the radiation beam in a field plane of the metrology tool.

The field plane may be referred to as a beam spot region or the field or the field of view (FOV) of the metrology tool. In some embodiments, each of the plurality of beam-modifying modules may be arranged to control a size and/or shape of the radiation beam in a plane that is close to a field plane of the metrology tool (and may be referred to as a "field-like plane").

Each of the plurality of beam-modifying modules may be arranged to control a size and/or shape of the radiation beam in a pupil plane of the metrology tool.

It will be appreciated that the pupil plane of the metrology tool is intended to mean a plane that is a Fourier transform plane of the beam spot region or field plane. That is, the intensity distribution of the radiation in the beam spot region is a Fourier transform of the intensity distribution of the radiation in the pupil plane. It will be appreciated that all rays from any given point in the pupil plane are mapped onto substantially the entire beam spot region. Put differently, the rays from any given point in the pupil plane illuminate the entire field of view (FOV) of the metrology tool. Similarly, a single point in the beam spot region maps onto substantially the entire pupil plane. The intensity distribution of the radiation in a pupil plane characterizes the angular distribution of radiation in a field plane (i.e. the beam spot region). In some embodiments, each of the plurality of beam-modifying modules may be arranged to control a size and/or shape of the radiation beam in a plane that is close to a pupil plane of the metrology tool (and may be referred to as a "pupil-like plane").

The metrology tool may further comprise a radiation source operable to produce the radiation that is received by the apparatus according to the first aspect of the present disclosure.

The radiation source may be a broadband radiation source. For example, the radiation source may be operable to produce radiation with a spectrum of around 400-900 nm.

The apparatus according to the first aspect of the present disclosure may be considered to be a radiation adjustment module operable to receive radiation from the radiation source and to output radiation having modified characteristics. The characteristics may comprise wavelength, bandwidth, polarization state etc. The radiation adjustment module may be adjustable so that the characteristics of the output radiation can be controlled.

The metrology tool may further comprise a support for supporting an object such that it is positionable so as to receive radiation from the apparatus according to the first aspect of the present disclosure.

The support for supporting an object may comprise a substrate holder operable to secure a substrate. For example, the support may comprise a clamp for clamping the substrate to the support. The support may comprise a stage such as a wafer stage.

The metrology tool may further comprise a movement mechanism operable to cause relative movement of the support and the apparatus according to the first aspect of the present disclosure.

This may allow the object or substrate to be stepped or scanned through the radiation. As used herein scanning of an object is intended to mean continuous movement of the object. As used herein stepping of an object is intended to mean movement of the object in a plurality of successive (temporally separated) steps.

According to a third aspect of the present disclosure there is provided a metrology method for determining one or more parameters of interest of a structure on an object, the metrology method comprising: making a plurality of successive measurements by: projecting radiation onto the structure; receiving at least a portion of the radiation scattered by the structure; and determining the measurement from the radiation scattered by the structure; wherein each of the plurality of successive measurements is made using radiation with different characteristics; and wherein the radiation used for at least two of the plurality of successive measurements is received from a different one of a plurality of beam-modifying modules, each of the plurality of beam-modifying modules being arranged to control the same at least one attribute of the radiation beam.

The method according to the third aspect of the present disclosure may be carried out using the apparatus according to the first aspect of the present disclosure. It will be appreciated that the method according to the third aspect of the present disclosure may comprise any corresponding features of the apparatus according to the first aspect of the present disclosure.

The metrology method may further comprise: re-configuring a second one of the plurality of beam-modifying modules while one of the plurality of successive measurements is being made using a first one of the plurality of beam-modifying modules.

That is, while the first one is being used for a measurement, the second one of the plurality of beam-modifying modules can be configured ready for the next measurement with that second beam-modifying module. For example, during one measurement using a first one of the plurality of beam-modifying modules, a second one of the plurality of beam-modifying modules can be configured ready for the next measurement. This avoids the need to wait for the time required to re-configure the beam-modifying module in between two successive measurements.

According to a fourth aspect of the present disclosure there is provided a metrology method for determining one or more parameters of interest of a structure on an object, the metrology method comprising: making at least one measurement during a measurement time period by: projecting radiation onto the structure; receiving at least a portion of the radiation scattered by the structure; and determining the measurement from the radiation scattered by the structure; wherein the measurement time period comprises a plurality of successive time portions and wherein the radiation used for at least two of the plurality of successive time portions is received from a different one of a plurality of beam-modifying modules, a size and/or shape of the radiation beam in a pupil plane being different for each of the plurality of beam-modifying modules.

The method according to the fourth aspect of the present disclosure may be carried out using the apparatus according to the first aspect of the present disclosure. It will be appreciated that the method according to the fourth aspect of the present disclosure may comprise any corresponding features of the apparatus according to the first aspect of the present disclosure.

The method according to the fourth aspect of the present disclosure may be combined with the method according to the third aspect of the present disclosure.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 is a schematic illustration of a metrology apparatus, such as a scatterometer, comprising a radiation projector and a spectrometer detector;
- Figures 5(a), 5(b), 5(c) and 5(d) comprise (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 6 depicts an alignment sensor;
- Figure 7 depicts a schematic representation of a known type of colour selection module;
- Figure 8 is a schematic illustration of a new apparatus for use in a metrology apparatus according to an embodiment of the present disclosure, which may form part of any type of metrology tool and/or may form part of a lithographic apparatus of the type shown in Figure 1;
- Figure 9A is a schematic illustration of a portion of a first embodiment of the apparatus shown in Figure 8, in an x-y plane and showing a movable optical element of the input optics in a first orientation;
- Figure 9B is a schematic illustration of a portion of the first embodiment of the apparatus shown in Figure 8 (as shown in Figure 9A), in an x-y plane and showing the movable optical element of the input optics in a second orientation;
- Figure 10A is a schematic illustration of a portion of the first embodiment in another x-y plane (parallel to the plane of Figures 9A and 9B), showing the movable optical element of the output optics in the first orientation (i.e. the same orientation as Figure 9A);
- Figure 10B is a schematic illustration of a portion of the first embodiment in another x-y plane (parallel to the plane of Figures 9A and 9B), showing the movable optical element of the output optics in the second orientation (i.e. the same orientation as Figure 9B);
- Figure 11A is a schematic illustration of a portion of the first embodiment (as shown in Figure 9A to 10B) in a first plane (containing the z-direction) that is perpendicular to the planes of Figures 9A to 10B also showing a first beam modifying module;
- Figure 11B is a schematic illustration of a portion of the first embodiment (as shown in Figure 9A to 10B) in a second plane (containing the z-direction) that is perpendicular to the planes of Figures 9A to 10B also showing a second beam modifying module;
- Figure 12 is a schematic illustration of a portion of a second embodiment of the apparatus shown in Figure 8, which comprises focusing optics;
- Figure 13 is a schematic illustration of a variant of the second embodiment (as shown in Figure 12) of the apparatus shown in Figure 8, which comprises a modified set of focusing optics;
- Figure 14A is a schematic side view of a portion of a third embodiment of the apparatus shown in Figure 8 that comprises a plurality of prisms;
- Figure 14B is a schematic end view of a portion of the third embodiment (as shown in Figure 14B) of the apparatus shown in Figure 8;
- Figure 15 is a schematic illustration of a new metrology tool for determining one or more parameters of interest of a structure on an object (for example a wafer) according to an embodiment of the present disclosure, which comprises the apparatus shown in Figure 8;
- Figure 16 is a schematic illustration of a first new metrology method for determining one or more parameters of interest of a structure on an object (for example a wafer) according to an embodiment of the present disclosure;
- Figure 17 is a schematic illustration of a second new metrology method for determining one or more parameters of interest of a structure on an object (for example a wafer) according to an embodiment of the present disclosure; and
- Figure 18 schematically shows an example of a pupil plane of a metrology tool during at least one measurement of the method shown schematically in Figure 17.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

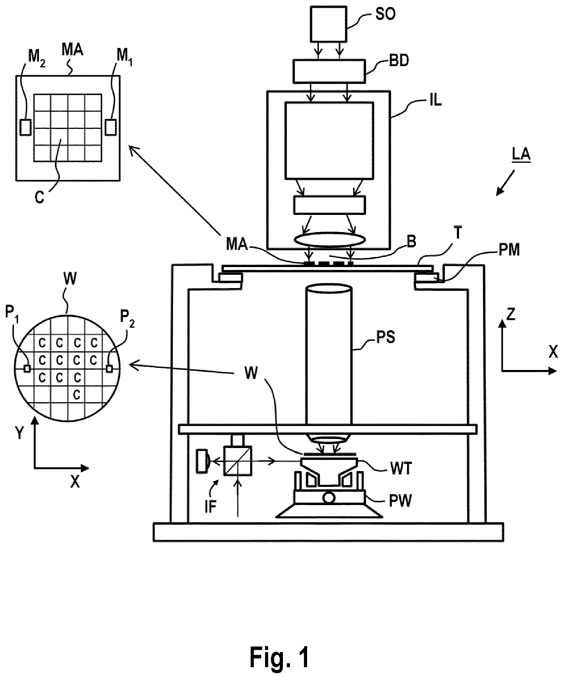

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

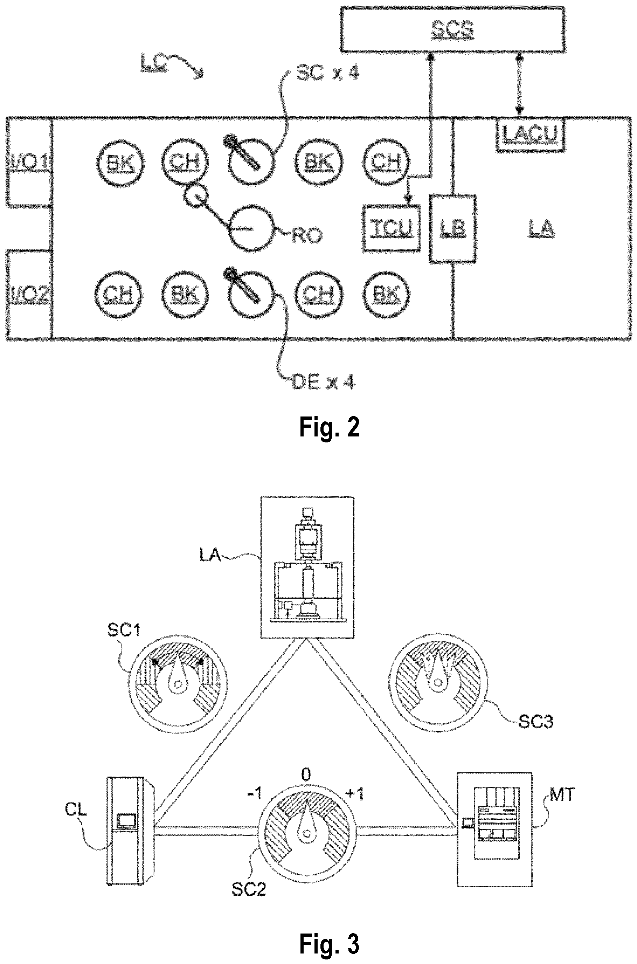

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to `overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

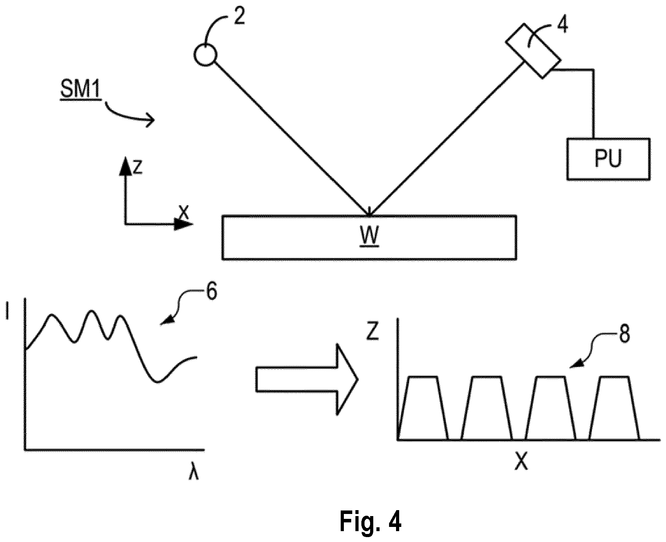

A metrology apparatus, such as a scatterometer, is depicted in Figure 4. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometter illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from from multiple gratings using light from soft x-ray and visible to near-IR wave range.

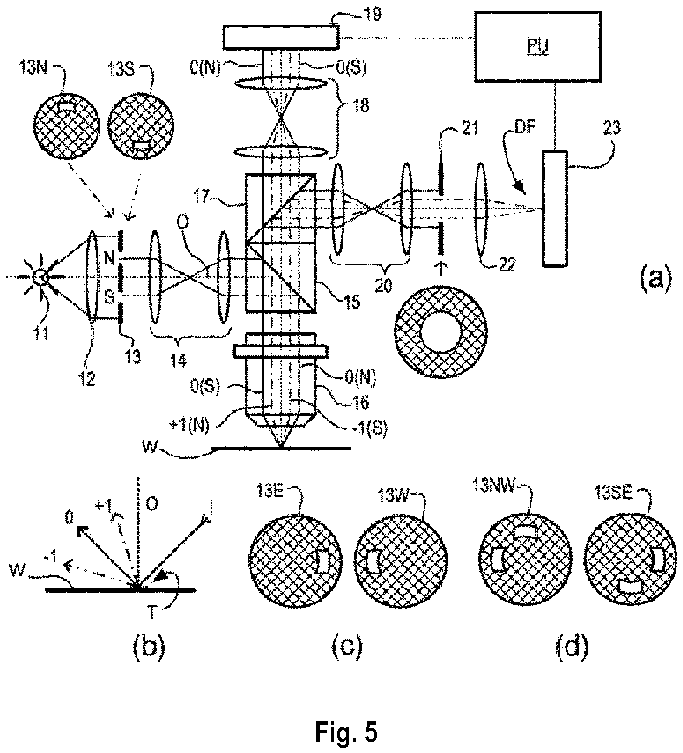

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a backprojected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

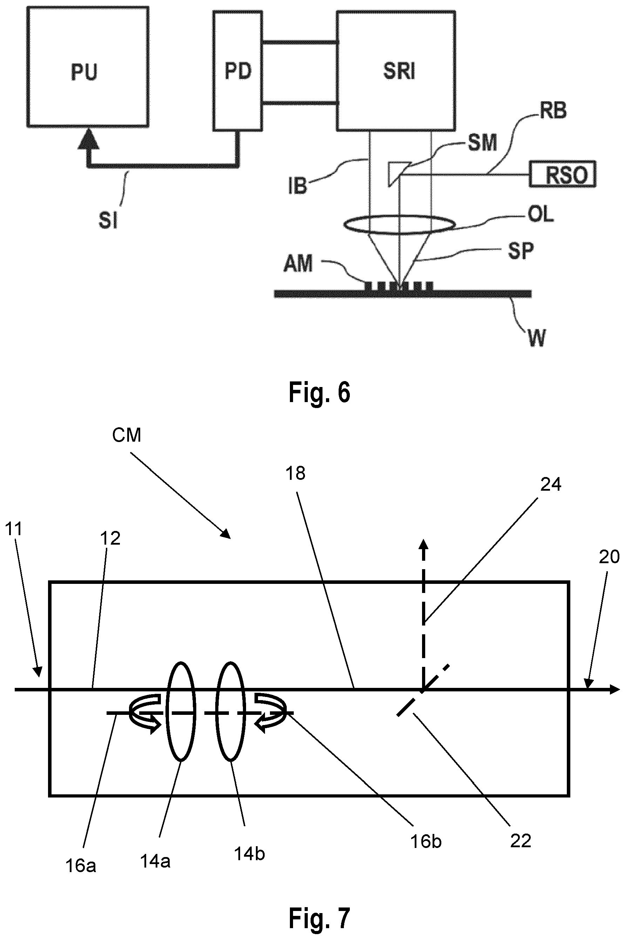

Figure 6 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and de-multiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

Metrology and/or inspection tools (also referred to as measurement tools) such as the ones described above often use radiation to obtain measurement data. Depending on the measurement target and the properties to be measured, different types of radiation may be used. One differing property of radiation is the wavelength(s) used to obtain a measurement, as different wavelengths may provide different information about a measurement target. Some measurement tools may use broadband radiation, such as supercontinuum radiation, either to measure using broadband radiation, or to be able to tune and select the measurement wavelength(s) to be used. Depending on the range of output wavelengths and properties of the broadband source, difference methods may be used to obtain the broadband radiation. In some implementations for generating broadband radiation, nonlinear effects may be used to broaden narrow wavelength range input radiation (also referred to as pump radiation). Different known setups and methods exist to achieve nonlinear broadening. Often these methods rely on the confinement of the pump radiation to achieve high intensities needed to experience significant nonlinear effects.

In order to provide a radiation source that is able to switch between desired wavelengths, the radiation source may include a colour selection module. A known example of such a colour selection module CM is depicted schematically in Figure 7. The colour selection module CM is provided with an input 11 for a beam of broadband radiation 12. The beam of radiation 12 passes through a pair of rotatable colour wheels 14a, 14b. The colour wheels 14a, 14b may each be considered to be multilayer (spectral) filters. That is to say, each colour wheel has a multilayer structure - each layer being formed from different materials each having a different transmission spectrum. The overall transmission spectrum of a particular portion of each colour wheel depends upon the thickness and material of each layer of the multilayer structure at said portion. One or more properties of the multilayer structure (e.g. thickness of each of the layers of the multilayer structure) is varied as a function of angular location around the wheel. As such, the overall transmission spectrum of each colour wheel varies as a function of angular location around the wheel. Each of the wheels 14a, 14b can be rotated about a respective rotation axis 16a, 16b. It follows that the overall transmission spectrum of each of the colour wheels 14a, 14b varies with angular orientation about the rotation axis 16a, 16b. By rotating each of the colour wheels 14a, 14b about their respective axis 16a, 16b and controlling the angular position of each of the colour wheels 14a, 14b, a portion of each of the colour wheels 14a, 14b through which the broadband radiation beam 12 passes can be controlled. This provides control over the overall transmission spectrum of the multilayer structure of said portion of each colour wheel 14a, 14b through which the radiation beam 12 passes. Therefore, this provides control over properties of a narrowband beam of radiation 18 which is output from the colour wheels 14a, 14b. For example, one of the colour wheels 14a may function as a low pass filter and the other of the colour wheels 14b may function as a high pass filter. By controlling the angular position of each of the colour wheels 14a, 14b, about their respective axis 16a, 16b the cut off frequency provided by the low pass filter of one of the colour wheels and the high pass filter of the other of the colour wheels can be varied. In this way, it is possible to control both a central wavelength and a spectral bandwidth of the narrowband radiation 18 which is output from the colour wheels 14a, 14b. The narrowband radiation 18 exits at an output 20 of the colour selection module CM.

The colour selection module CM may also include a reflector 22 which creates a secondary beam path 24. A portion of the radiation 18 that is directed along this secondary beam path 24 can be used to measure properties of the narrowband radiation 18 as the colour selection module CM is operating, which may be used to calibrate the colour selection module CM. For example, the portion of the radiation 18 that is directed along this secondary beam path 24 may be used to ensure that when the colour wheels 14a, 14b are in particular positions a desired central wavelength and spectral bandwidth of narrowband radiation 18 is output by the colour selection module CM.

The colour wheels 14a, 14b may be relatively large (as their size may be, in part, dictated by the properties of the multilayer structures which form part of each of the colour wheels and which may need to be of particular size to enable a desired degree of spatial resolution depending on the angular position of the colour wheels). A switching speed of the colour selection module CM may be dependent on: (a) the masses of the colour wheels 14a, 14b; and (b) the typical distances by which each of the colour wheels are moved so as to change the central wavelength and spectral bandwidth of the narrowband radiation 18 output by the colour selection module CM. As used herein a switching speed of the colour selection module CM is intended to mean a time taken to switch between (i) a first desired central wavelength and spectral bandwidth of narrowband radiation 18 and (ii) a second desired central wavelength and spectral bandwidth of narrowband radiation 18.

Other properties of radiation that may be varied over a plurality of measurements in a metrology tool include: (a) the shape of the radiation beam in a pupil plane of the metrology tool (which corresponds to the angular distribution of the radiation on the wafer); (b) the size of the radiation beam in a field plane of the metrology tool (i.e. the size of the field that is illuminated); and (c) the polarization of the radiation beam.

Each of these properties of radiation may be controlled by an apparatus that is configurable in a plurality of different configurations, each one corresponding to a different value of that property. Within such apparatus, there is a non-zero timescale for switching between any two configurations and these timescales may be different for different apparatus (that control difference properties or attributes of the radiation). For example, controlling the shape of a radiation beam in a pupil plane of a metrology tool may have a switching time of the order of 10 ms; controlling the wavelength and/or bandwidth of a radiation beam in a metrology tool may have a switching time of the order of 10 ms; and controlling a size of a radiation beam in a field plane of a metrology tool may have a switching time of the order of 100-500 ms.

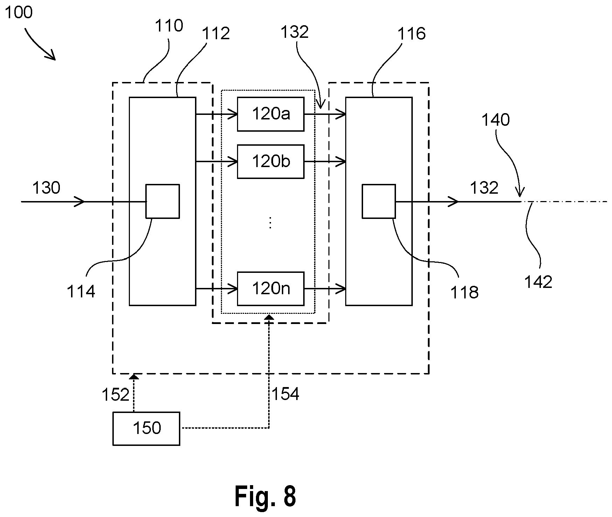

Some embodiments of the present disclosure relate to an apparatus for use in a metrology apparatus. An example of such an apparatus 100 for use in a metrology apparatus is shown schematically in Figure 8. The apparatus 100 may form part of any type of metrology tool, for example one of the examples discussed above, and/or may form part of a lithographic apparatus of the type shown in Figure 1.

The apparatus 100 comprises selection optics 110 and a plurality of beam-modifying modules 120a-120n.

The selection optics 110 is arranged to receive an input radiation beam 130 and is configurable so as direct the radiation beam 130 to any one of the plurality of beam-modifying modules 120a-120n.

In general, the selection optics 110 comprises input optics 112 disposed optically upstream of the plurality of beam-modifying modules 120a-120n. A configuration of the input optics 112 may determine which of the plurality of beam-modifying modules 120a-120n the radiation beam is directed to. It will be appreciated that the input optics 112 being optically upstream of the plurality of beam-modifying modules 120a-120n is intended to mean that radiation (originating from the radiation beam 130) is incident on the input optics 112 before the plurality of beam-modifying modules 120a-120n. The input optics 112 may comprise at least one movable optical element 114.

Optionally, in some embodiments, the selection optics 110 may also be arranged to receive secondary radiation 132 output by any one of the plurality of beam-modifying modules 120a-120n and may be configurable so as direct the secondary radiation 132 received from any one of the plurality of beam-modifying modules to a common output 140. That is, the selection optics 110 may be configurable so as to direct secondary radiation 132 to the common output 140 regardless of the beam-modifying module 120a-120n from which it was received. The selection optics 110 may be configurable so as direct the secondary radiation 132 received from any one of the plurality of beam-modifying modules 120a-120n to the common output 140 along a common trajectory 142.

In some embodiments, the out-coupling of the secondary radiation 132 from the apparatus 100 may be achieved using an out-coupling optical fiber (not shown). For such embodiments, it may be important that an angle of incidence of the secondary radiation 132 onto an end of the fiber is generally perpendicular with a surface of the fiber end.

Optionally, the selection optics 110 may comprise output optics 116 disposed optically downstream of the beam-modifying modules 120a-120n. A configuration of the output optics 116 may determines where secondary radiation 132 output by one of the plurality of beam-modifying modules 120a-120n is directed to. It will be appreciated that output optics 116 being optically downstream of the plurality of beam-modifying modules 120a-120n is intended to mean that radiation (originating from the radiation beam) is incident on the plurality of beam-modifying modules 120a-120n before the output optics 116. The output optics 116 may comprise at least one movable optical element 118.

A configuration of the selection optics may refer to both a configuration (for example orientation and/or position) of the input optics 112 and a configuration (for example orientation and/or position) of the output optics 116.

The selection optics 110 may be configurable in any one of a plurality of configurations, each one corresponding to a different one of the plurality of beam-modifying modules 120a-120n. When the selection optics 110 is configured in a configuration corresponding to a first one of the beam-modifying modules 120a, the input optics 112 may be configured so as direct the radiation beam 130 to the first beam-modifying module 120a and the output optics 116 may be configured so as direct the secondary radiation 132 from the first beam-modifying module 120a to the common output 140.

Each of the plurality of beam-modifying modules 120a-120n is arranged to control the same at least one attribute of the radiation beam 130. Upon receipt of the radiation beam 130, each of the plurality of beam-modifying modules 120a-120n may output secondary radiation 132 having a different state of the at least one attribute.

In some embodiments, each of the plurality of beam-modifying modules 120a-120n may be arranged to control a wavelength of the radiation beam 130. For example, each of the plurality of beam-modifying modules 120a-120n may comprise a colour selection module (for example a colour selection module CM of the type shown in Figure 7.

In some embodiments, each of the plurality of beam-modifying modules 120a-120n may be arranged to control a polarization state of the radiation beam 130.

In some embodiments, each of the plurality of beam-modifying modules 120a-120n may be arranged to control a size and/or shape of the radiation beam 130. It will be appreciated that, in general, the radiation beam 130 may not have a sharp edge (i.e. it may be that the intensity distribution is not described by a step function at the edge of the radiation beam 130). Rather, more realistically, at the "edges" of the radiation beam 130 the spatial intensity distribution may fall to zero (or a negligible value) over an edge region having a non-zero size. The "shape" of the radiation beam 130 may be defined as the shape of a region in which the intensity of the radiation beam 130 is above a threshold value (which may be some small percentage of an intensity in a central portion of the radiation beam 130). Additionally or alternatively, the "shape" of the radiation beam 130 may also describe how the intensity of the radiation beam 130 falls off over the edge region. This may be described as an edge profile. As used herein the "shape" of the radiation beam 130 is intended to mean any aspect of the spatial intensity distribution of the radiation beam 130. In particular, each of the plurality of beam-modifying modules 120a-120n may be arranged to control a size and/or shape of the radiation beam 130 in any plane as desired or required. When the apparatus 100 forms part of a metrology apparatus, the plane may be a pupil plane or a field plane of the metrology apparatus or an intermediate plane within the metrology apparatus.

The apparatus 100 shown schematically in Figure 8 is advantageous, as now discussed. As discussed above, metrology apparatus may be used to inspect or qualify objects. For example, a metrology apparatus may be used to measure overlay of silicon wafers W (i.e. how misaligned two subsequently formed lithographic layers are). It is desirable to make such measurements a plurality of times with different radiation beam attributes. Therefore, within a metrology apparatus there is often a beam-modifying module that can control one or more attributes of the radiation beam (for example, wavelength, beam size, beam shape, polarization). An example of a beam-modifying module is a colour selection module that can be used to control the wavelength of the output radiation beam.

Between two successive measurements made while using a given beam-modifying module 120a-120n, that beam-modifying module 120a-120n may be re-configured to as to modify one or more attribute of the radiation beam 130 (so that the two successive measurements can be made using radiation 132 with different attributes).

Advantageously, by providing a plurality of beam-modifying modules 120a-120n and selection optics 110 that is configurable so as direct radiation 130 to any one of the plurality of two beam-modifying modules 120a-120n, a throughput of the apparatus 100 can be improved. For example, during one measurement using a first one of the plurality of beam-modifying modules 120a, a second one of the plurality of beam-modifying modules 120b can be configured ready for the next measurement. This avoids the need to wait for the time required to re-configure the beam-modifying module 120b in between two successive measurements.

Furthermore, the selection optics 110 may comprise relatively small and relatively simple optics. For example, the selection optics 110 may comprise one or more fast mirrors. Therefore, the time scale required to switch from one of the beam-modifying modules 120a-120n to another of the beam-modifying modules 120a-120n can be significantly smaller than a typical time scale for re-configuring a beam-modifying module 120a-120b so as to modify one or more attribute of the radiation beam 130.

Furthermore, by providing a plurality of beam-modifying modules 120a-120n a significantly larger range of beam attribute values can be made available as compared to known arrangements.

As used herein, the term "attribute of a radiation beam" may be synonymous with the terms "characteristic of a radiation beam" and "property of a radiation beam". That is, in this context the words "attribute" "characteristic" and "property" may be mutually synonymous.

Optionally, the apparatus 100 may further comprise a controller 150 operable to control the selection optics 110; and/or the plurality of beam-modifying modules 120a-120n. For example, the controller 150 may be operable to re-configure the selection optics 110 and/or the beam-modifying optics 120a-120n. The controller 150 may be operable to control the selection optics 110 via a control signal 152. The controller 150 may be operable to control the plurality of beam-modifying modules 120a-120n via a control signal 154.

In some embodiments, the selection optics 110 may comprise one or more optical elements that are configurable in a plurality of different configurations. For example, the input optics 112 may comprise at least one configurable optical element and the output optics 116 may comprise at least one configurable optical element.

For example, such an optical element that is configurable in a plurality of different configurations may comprise an optical element that is movable (e.g. relative to the radiation 130, 132) such that it can be disposed in a plurality of different positions or orientations. Such optical elements may comprise reflective optical elements. Examples of suitable reflective optical elements include, for example, mirrors and prisms (for example used so as to achieve total internal reflection). Additionally or alternatively, such optical elements may comprise deflective optical elements. Examples of suitable deflective optical elements include, for example, refractive elements such as prisms arranged for the radiation beam to pass through (i.e. not used to achieve total internal reflection).

Additionally or alternatively, such an optical element that is configurable in a plurality of different configurations may comprise an acousto-optical deflector, elctro-optics or the like and which is arranged to deflect the radiation in a controllable manner.

In some embodiments, the selection optics 110 comprises one or more movable reflective optical elements. For example, the input optics 112 may comprise at least one movable reflective optical element and the output optics 116 may comprise at least one movable reflective optical element. It will be appreciated that a movable reflective optical element may be considered to be an example of an optical element that is configurable in a plurality of different configurations.

A reflective optical element is intended to mean any element comprising a reflective surface. Such reflective optical elements include, for example, mirrors and prisms.

As discussed below, for embodiments wherein the selection optics 110 comprises a plurality of movable reflective optical elements, the plurality of movable reflective optical elements may share a common support and/or a common movement mechanism.

In some embodiments, the selection optics 110 may be configurable in a finite number of discrete configurations, each such discrete configuration corresponding to a different one or the beam-modifying modules 120a-120n. That is, the selection optics 110 may comprise one or more optical elements that act as a fast switch with 2, 3, ..., n different configurations. Such an arrangement may be more stable and faster than arrangements wherein the selection optics 110 are configurable in a continuum of different configurations.

In some embodiments, the input optics 112 and the output optics 116 may share a common support. Advantageously, this may allow for both of the input optics 112 and the output optics 116 to be controlled by a common movement mechanism and/or may help to synchronize movement of the input optics 112 and the output optics 116. The input optics 112 and/or output optics 116 may each be movable relative to the common support.

In some embodiments, the input optics 112 and the output optics 116 may share a common movement mechanism. Advantageously, this may help to synchronize movement of the input optics 112 and the output optics 116 as a single mechanism is responsible for moving both.

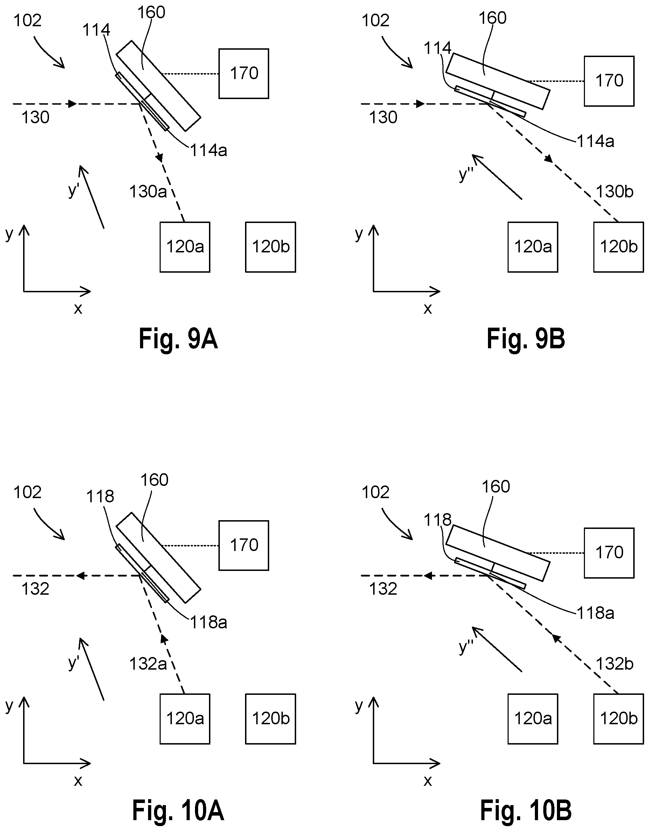

An example of an embodiment 102 that may be used to allow the input optics 112 and the output optics 116 to share a common support and/or movement mechanism is now described with reference to Figures 9A to 11B. The embodiment 102 may form part of the apparatus 100 shown schematically in Figure 8. For ease of understanding, and so as to not overly complicate the Figures, the embodiment 102 shown in Figures 9A to 11B only comprises two beam-modifying modules 120a, 120b. However, it will be apparent to the skilled person that such an arrangement could be generalized to comprise more than two beam-modifying modules.

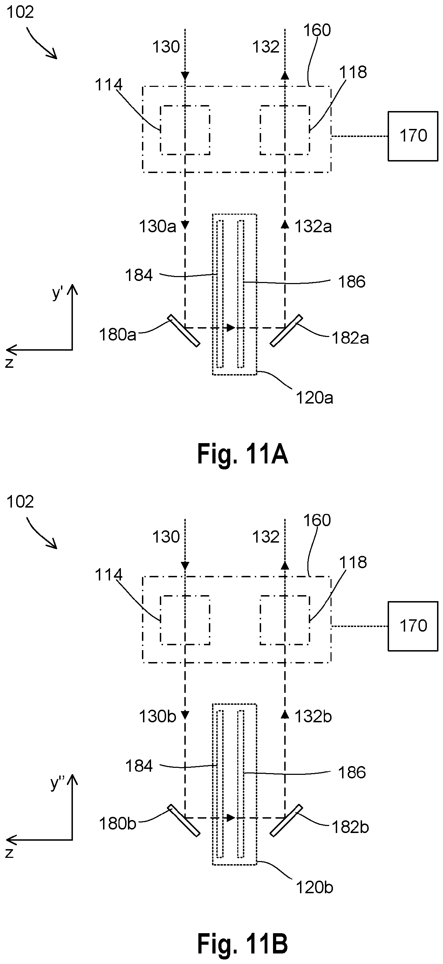

Figures 9A and 9B show a portion of the embodiment 102 in an x-y plane, each showing a movable optical element 114 of the input optics 112 in a different orientation. Figures 10A and 10B show a portion of the embodiment 102 in another x-y plane (parallel to the plane of Figures 9A and 9B), each showing a movable optical element 118 of the output optics 116 in a different orientation. Figure 11A shows a portion of the embodiment 102 in first plane (containing the z-direction) that is perpendicular to the planes of Figures 9A to 10B showing a first beam modifying module 120a. Figure 11B shows a portion of the embodiment 102 in a second plane (containing the z-direction) that is perpendicular to the planes of Figures 9A to 10B showing a second beam modifying module 120b.

As shown in Figures 9A and 9B, the input radiation beam 130 propagates in the x-direction and is incident on the movable optical element 114 of the input optics 112. The movable optical element 114 of the input optics 112 is rotatable about an axis of rotation 114a and is positionable in at least two orientations.

When disposed in a first orientation (see Figure 9A), the movable optical element 114 of the input optics 112 directs the radiation beam 130 towards a first beam-modifying module 120a. When the movable optical element 114 of the input optics 112 is in this first orientation, after being re-directed by the movable optical element 114, the radiation 130 forms a first intermediate input radiation beam 130a. The first intermediate input radiation beam 130a propagates in a direction labelled as the negative y'-direction.

When disposed in a second orientation (see Figure 9B), the movable optical element 114 of the input optics 112 directs the radiation beam 130 towards a second beam-modifying module 120b. When the movable optical element 114 of the input optics 112 is in this second orientation, after being re-directed by the movable optical element 114, the radiation 130 forms a second intermediate input radiation beam 130b. The second intermediate input radiation beam 130b propagates in a direction labelled as the negative y"-direction.

As shown in Figures 10A and 10B, the output radiation beam 132 propagates in the (negative) x-direction and is output via the movable optical element 118 of the output optics 116. The movable optical element 118 of the output optics 116 is rotatable about an axis of rotation 118a and is positionable in at least two orientations.

When disposed in a first orientation (see Figure 10A), the movable optical element 118 of the output optics 116 is arranged to receive secondary radiation 132a from the first beam-modifying module 120a and to direct it as secondary radiation 132 along the negative x-direction. Secondary radiation output by the first beam-modifying module 120a may be referred to as first secondary radiation 132a. The first secondary radiation 132a propagates in a direction labelled as the positive y'-direction.

When disposed in a second orientation (see Figure 10B), the movable optical element 118 of the output optics 116 is arranged to receive secondary radiation 132b from the second beam-modifying module 120b and to direct it as secondary radiation 132 along the negative x-direction. Secondary radiation output by the second beam-modifying module 120b may be referred to as second secondary radiation 132b. The second secondary radiation 132b propagates in a direction labelled as the positive y" -direction.

In the embodiment shown in Figures 9A to 11B, the movable optical element 114 of the input optics 112 and the movable optical element 118 of the output optics 116 share a common support 160. Advantageously, this may allow for both of the movable optical elements 114, 118 to be controlled by a common movement mechanism and/or may help to synchronize movement of the two optical elements 114, 116. Note that the movable optical element 114 of the input optics 112 and the movable optical element 118 of the output optics 116 may each be movable relative to the common support 160.

In the embodiment shown in Figures 9A to 11B, the movable optical element 114 of the input optics 112 and the movable optical element 118 of the output optics 116 share a common movement mechanism 170. The movement mechanism 170 is operable to move both the movable optical element 114 of the input optics 112 and the movable optical element 118 of the output optics 116.

Figure 11A shows a portion of the embodiment 102 in the y'-z plane (which may be referred to as a first plane containing the z-direction) showing the first beam modifying module 120a. In this embodiment, the first intermediate input radiation beam 130a (which propagates in the negative y' -direction) is directed through a main portion of the first beam-modifying module 120a by a first mirror 180a. Once the radiation has passed through the main portion of the first beam-modifying module 120a (and has become the first secondary radiation 132a) it is directed towards the movable optical element 118 of the output optics 116 by a second mirror 182a.

Figure 11B shows a portion of the embodiment 102 in the y"-z plane (which may be referred to as a second plane containing the z-direction) showing the second beam modifying module 120b. In this embodiment, the second intermediate input radiation beam 130b (which propagates in the negative y"-direction) is directed through a main portion of the second beam-modifying module 120b by a first mirror 180b. Once the radiation has passed through the main portion of the second beam-modifying module 120b (and has become the second secondary radiation 132b) it is directed towards the movable optical element 118 of the output optics 116 by a second mirror 182b.

Optionally, each of the first and second beam-modifying modules 120a, 120b may be of the form of a colour selection module, for example a colour selection module CM of the type shown schematically in Figure 7. As indicated very schematically in Figures 11A and 11B, each of the first and second beam-modifying modules 120a, 120b may comprise a pair of rotatable colour wheels 184, 186, which may be generally of the form of the colour wheels 14a, 14b shown in Figure 7 and described above. Alternatively, each of the first and second beam-modifying modules 120a, 120b may comprise any other form of colour selecting or filtering means.

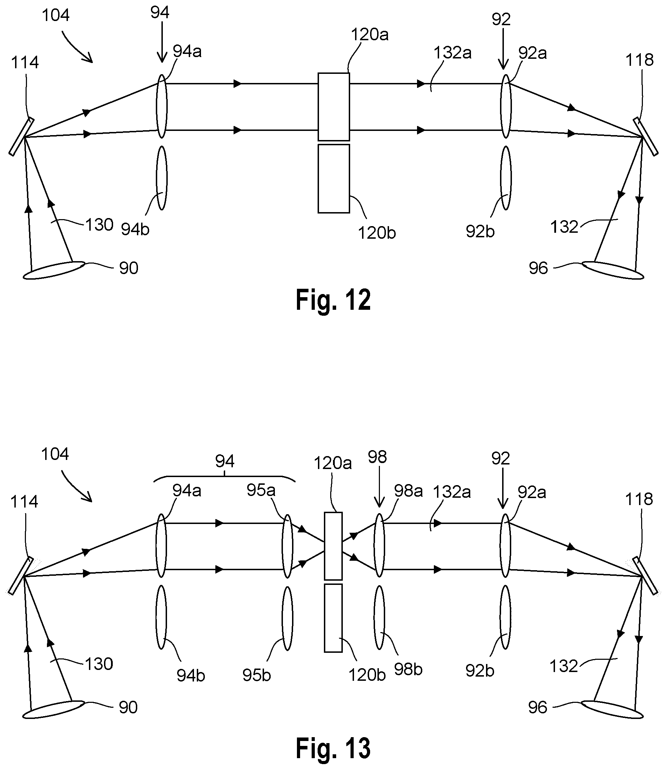

Some embodiments of the apparatus 100 shown in Figure 8 further comprising various focusing optics, as now discussed with reference to Figures 12 and 13.

An example of an embodiment 104 that comprises focusing optics is now described with reference to Figures 12 and 13. The embodiment 104 may form part of the apparatus 100 shown schematically in Figure 8. For ease of understanding, and so as to not overly complicate the Figures, the embodiment 104 shown in Figures 12 to 13 only comprises two beam-modifying modules 120a, 120b. However, it will be apparent to the skilled person that such an arrangement could be generalized to comprise more than two beam-modifying modules.

The embodiment 104 shown in Figures 12 and 13 may be combined with the embodiment 102 shown in Figures 9A to 11B.

The embodiment 104 of the apparatus 100 shown in Figures 12 and 13 further comprises focusing optics arranged to focus the radiation beam 130 in the vicinity of one or more movable optical elements 114, 118 of the selection optics 110. In particular, the embodiment 104 of the apparatus 100 shown in Figures 12 and 13 comprises focusing optics 90 arranged to focus the radiation beam 130 in the vicinity of a movable optical element 114 of the input optics 112 and focusing optics 92 arranged to focus the secondary radiation 132 in the vicinity of a movable optical element 118 of the output optics 116.

Such an arrangement reduces a size of the radiation beam 130 in the vicinity of the movable optical element 114 of the input optics 112 and reduces a size of the secondary radiation beam 132 in the vicinity of the movable optical element 118 of the output optics 118. Advantageously, this allows for the size of these movable optical elements 114, 118 to be reduced and, in turn, allows these movable optical elements 114, 118 to be moved or re-configured faster. The one or more movable optical elements 114, 118 of the selection optics 110 may comprise (at least a part of) the input optics 112 and/or (at least a part of) the output optics 116.

In this embodiment 104, the focusing optics 92 arranged to focus the secondary radiation 132 in the vicinity of a movable optical element 118 of the output optics 116 comprises a focusing optical element 92a, 92b for the secondary radiation 132a, 132b output by each of the beam-modifying modules 120a, 120b.

This embodiment 104 further comprises focusing optics downstream of each movable optical element 114, 118 of the selection optics 110 that is arranged to decrease a divergence of the radiation. In particular, this embodiment 104 further comprises focusing optics 94 downstream of the movable optical element 114 of the input optics 112 that is arranged to decrease a divergence of the radiation downstream of the movable optical element 114. In addition, this embodiment 104 further comprises focusing optics 96 downstream of the movable optical element 118 of the output optics 116 that is arranged to decrease a divergence of the radiation downstream of the movable optical element 118.

The focusing optics 94, 96 downstream of the movable optical elements 114, 118 may be arranged to collimate the radiation.

In some embodiments, the focusing optics 94 downstream of the movable optical element 114 of the input optics 112 may be arranged to focus the radiation 130 in the vicinity of the beam-modifying modules 120a, 120b. Such an arrangement is now described with reference to Figure 13.

The embodiment 104 shown in Figure 13 is identical to that shown in Figure 12 with the exception that the focusing optics 94 downstream of the movable optical element 114 of the input optics 112 now comprises both collimating optics 94a, 94b and focusing optics 95a, 95b arranged to focus the radiation 130 in the vicinity of the beam-modifying modules 120a, 120b. In addition, downstream of the beam-modifying modules 120a, 120b, additional collimating optics 98 are provided (again comprising a collimating optical element 98a, 98b for the secondary radiation from each of the beam-modifying modules 120a, 120b).

The arrangement 104 shown in Figure 13 may be employed for embodiments wherein the beam-modifying modules 120a, 120b are arranged to control the wavelength and/or bandwidth of the secondary radiation 132. The arrangement 104 shown in Figure 12 may be employed for embodiments wherein the beam-modifying modules 120a, 120b are arranged to control the shape of radiation in a pupil plane of a metrology tool.

In some embodiments of the apparatus 100 shown in Figure 8, a timescale for switching between two configurations of the selection optics 110 may be of the order of 2 ms or less. In some embodiments, a timescale for switching between two configurations of the selection optics 110 may be of the order of 1 ms or less.

In some embodiments of the apparatus 100 shown in Figure 8, each of the plurality of beam-modifying modules 120a-120n may be configurable in any one of a plurality of different configurations, wherein the at least one attribute of the secondary radiation 132 is different for each of the plurality of different configurations. For example, each of the beam-modifying modules 120a-120n may comprise a colour selection module (for example of the type of colour selection module CM shown in Figure 7) that can be used to control the wavelength of the secondary radiation 132 by control of the configuration of that colour selection module.

For such embodiments, a timescale for switching between two configurations of any one of the beam-modifying module 120a-120n may be larger than a timescale for switching between two configurations of the selection optics 110. For example, in some embodiments, a timescale for switching between two configurations of any one of the beam-modifying module 120a-120n is of the order of 10 ms to 100 ms or more whereas a timescale for switching between two configurations of the selection optics 110 is of the order of 1 ms.

In some embodiments, a timescale for switching between two configurations of any one of the beam-modifying modules 120a-120n is of the order of 5 ms or more. For example, in some embodiments, a timescale for switching between two configurations of any one of the beam-modifying modules may be of the order of 10 ms to 100 ms or more.

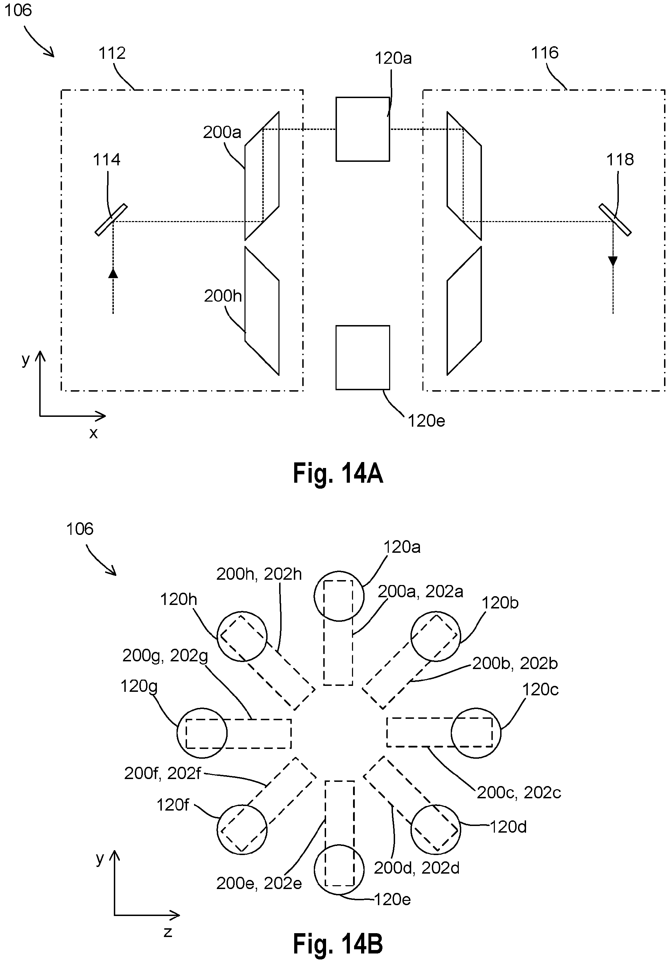

Figures 14A and 14B show another embodiment 106 that comprises a plurality of prisms, as now discussed.

The embodiment 106 may form part of the apparatus 100 shown schematically in Figure 8. The embodiment 106 shown in Figures 14A and 14B may be combined with the embodiment 102 shown in Figures 9A to 11B and/or the embodiment 104 shown in Figures 12 and 13.

As best seen in Figure 14B, the embodiment 106 shown in Figures 14A and 14B comprises eight beam-modifying modules 120a-120h, which are arranged in a circular arrangement. It will be appreciated that the embodiment 106 shown in Figures 14A and 14B is merely an example. Other similar embodiments may comprise any number (greater than one) of beam-modifying modules 120a-120n (for example between two and seven or greater than eight), which may also be arranged in a circular arrangement.

In addition to the movable optical element 114, the input optics 112 comprises a plurality of prisms 200a-200h, one for each of the eight beam-modifying modules 120a-120h. Furthermore, in addition to the movable optical element 118, the output optics 116 comprises a plurality of prisms 202a-202h, one for each of the eight beam-modifying modules 120a-120h.

With this arrangement, the movable optical elements 114, 118 may each be operable to rotate and/or translate. Furthermore, each of the movable optical elements 114, 118 may comprise a plurality of independently movable elements.

The embodiment 106 shown in Figures 14A and 14B uses total internal reflection within the prisms 200a-200h, 202a-202h to direct the radiation 130, 132. Advantageously, this limits photon loss through the apparatus 100.

In the embodiment 106 shown in Figures 14A and 14B the out-coupling of the secondary radiation from the embodiment 106 can be achieved using an out-coupling optical fiber. For such embodiments, it may be important that the angle of incidence of the secondary radiation onto an end of the fiber is generally perpendicular with a surface of the fiber end.

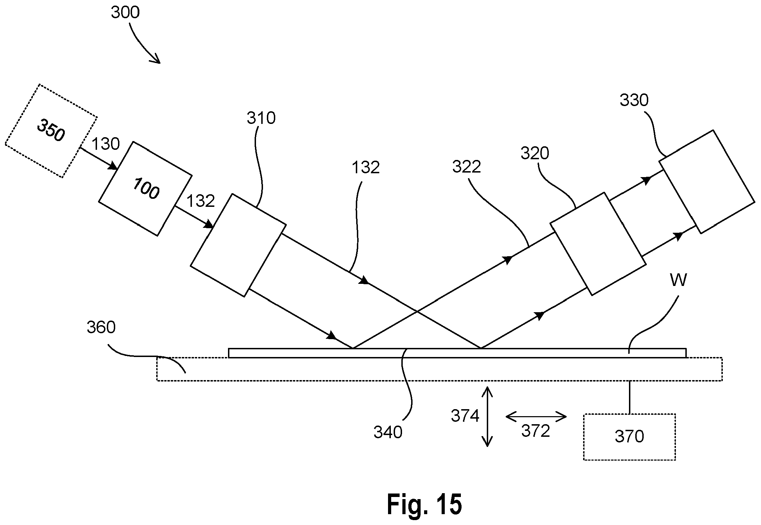

Some embodiments of the present disclosure relate to a metrology tool for determining one or more parameters of interest of a structure on an object (for example a wafer W) that comprises the apparatus 100 shown in Figure 8. An example of such a metrology tool 300 is shown schematically in Figure 15.

The metrology tool 300 comprises: projection optics 310, detection optics 320 and a detector 330. The projection optics 310 is arranged to project radiation 132 output by the apparatus 100 shown in Figure 8 onto a beam spot region 340 in which the structure is positionable. The detection optics 320 is arranged to receive at least a portion of radiation 322 scattered by the structure. The detector 330 is operable to determine one or more parameters (for example overlay) from the received scattered radiation 322.

When performing lithographic processes it is desirable to make frequent measurements of the structures created, for example, for process control and verification. Tools to make such measurements are typically called metrology tools. For example, some metrology tools make overlay measurements, which exploit the fact that the diffraction efficiencies of periodic structures are dependent on the unit cell of the periodic structure (and, therefore, any asymmetry of the unit cell). The response of such measurements is sensitive to the wavelength of radiation used by the scatterometer. Furthermore, it is desirable to separate out any imbalance in the relative intensities of certain diffraction orders that is due to overlay errors and other sources of such imbalances. For this reason, these scatterometry metrology tools often make a plurality of separate, sequential measurements of each metrology mark with different wavelengths of radiation, which are then combined. The specific wavelengths (and bandwidths) are typically dependent on the specific lithographic process or recipe and are typically optimized for a given process so as to maximize the response to overlay errors.

In some embodiments of the metrology tool 300, each of the plurality of beam-modifying modules 120a-120n may be arranged to control a size and/or shape of the radiation beam 132 in a field plane of the metrology tool. The field plane may be referred to as a beam spot region 340 or the field or the field of view (FOV) of the metrology tool 300.

In some embodiments of the metrology tool 300, each of the plurality of beam-modifying modules 120a-120n may be arranged to control a size and/or shape of the radiation beam in a pupil plane of the metrology tool 300.

It will be appreciated that the pupil plane of the metrology tool 300 is intended to mean a plane that is a Fourier transform plane of the beam spot region 340 or field plane. That is, the intensity distribution of the radiation in the beam spot region 340 is a Fourier transform of the intensity distribution of the radiation in the pupil plane. It will be appreciated that all rays from any given point in the pupil plane are mapped onto substantially the entire beam spot region 340. Put differently, the rays from any given point in the pupil plane illuminate the entire field of view (FOV) 340 of the metrology tool. Similarly, a single point in the beam spot region 340 maps onto substantially the entire pupil plane. The intensity distribution of the radiation in a pupil plane characterizes the angular distribution of radiation in a field plane (i.e. the beam spot region 340).

Optionally, the metrology tool 300 may further comprise a radiation source 350 operable to produce the radiation 130 that is received by the apparatus 100. The radiation source 350 may be a broadband radiation source. For example, the radiation source 350 may be operable to produce radiation with a spectrum of around 400-900 nm.

The apparatus 100 shown in Figure 8 may be considered to be a radiation adjustment module operable to receive radiation 130 from the radiation source 350 and to output radiation having modified characteristics. The characteristics may comprise wavelength, bandwidth, polarization state etc. The radiation adjustment module 100 may be adjustable so that the characteristics of the output radiation can be controlled.

Optionally, the metrology tool 300 may further comprise a support 360 for supporting an object (for example a wafer W) such that it is positionable so as to receive radiation 132 from the apparatus 100 shown in Figure 8. The support 360 for supporting an object may comprise a substrate holder operable to secure a substrate W. For example, the support 360 may comprise a clamp for clamping the substrate W to the support 360. The support 360 may comprise a stage such as a wafer stage WT or wafer table WT (see Figure 1).

Optionally, the metrology tool 300 may further comprise a movement mechanism 370 operable to cause relative movement of the support 360 and the apparatus 100 shown in Figure 8 (indicated schematically by arrows 372, 374). This may allow the object or substrate W to be stepped or scanned through the radiation 132 in the beam spot region 340. As used herein scanning of an object is intended to mean continuous movement of the object. As used herein stepping of an object is intended to mean movement of the object in a plurality of successive (temporally separated) steps.

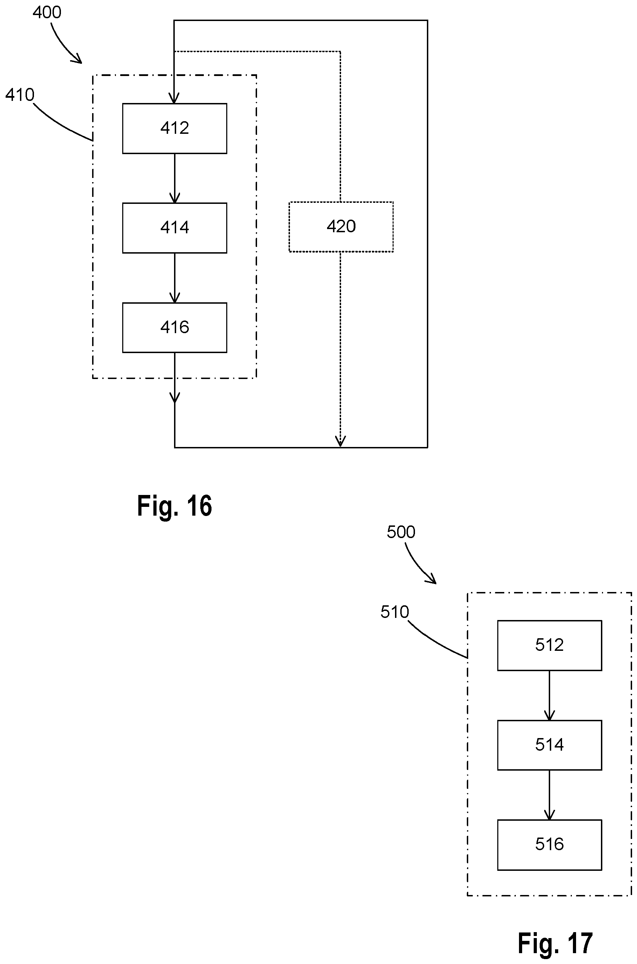

Some embodiments of the present disclosure relate to a metrology method for determining one or more parameters of interest of a structure on an object (for example a wafer W). A first example of such a metrology method 400 is shown schematically in Figure 16.

The metrology method 400 comprises making a plurality of successive measurements 410. Each of the plurality of successive measurements 410 comprises the following steps: a step 412 of projecting radiation 132 onto the structure; a step 414 of receiving at least a portion of the radiation 322 scattered by the structure; and a step 416 of determining the measurement from the radiation 322 scattered by the structure.

Each of the plurality of successive measurements 410 is made using radiation 132 with different characteristics. Furthermore, the radiation 132 used for at least two of the plurality of successive measurements 410 is received from a different one of a plurality of beam-modifying modules 120a-120n, each of the plurality of beam-modifying modules 120a-120n being arranged to control the same at least one attribute of the radiation beam 132. In some embodiments, the radiation 132 used for at least two of the plurality of successive measurements 410 may be received from the same beam-modifying module 120a-120n.

The method 400 shown in Figure 16 may be carried out using the apparatus 100 shown in Figure 8. It will be appreciated that the method 400 shown in Figure 16 may comprise any corresponding features of the apparatus 100 shown in Figure 8.

Optionally, the metrology method 400 may further comprise a step 420 of re-configuring a second one of the plurality of beam-modifying modules 120a-120n while one of the plurality of successive measurements 410 is being made using a first one of the plurality of beam-modifying modules 120a-120n.

That is, while the first one of the plurality of beam-modifying modules 120a-120n is being used for a measurement, the second one of the plurality of beam-modifying modules 120a-120n can be configured ready for the next measurement with that second beam-modifying module 120a-120n. For example, during one measurement 410 using a first one of the plurality of beam-modifying modules 120a, a second one of the plurality of beam-modifying modules 120b can be configured ready for the next measurement. This avoids the need to wait for the time required to re-configure the beam-modifying module 120b in between two successive measurements 410.

A second example of a metrology method 500 for determining one or more parameters of interest of a structure on an object (for example a wafer W) is shown schematically in Figure 17.

The metrology method 500 comprises making at least one measurement 510 during a measurement time. The at least one measurement 510 comprises: a step 512 of projecting radiation 132 onto the structure; a step 514 of receiving at least a portion of the radiation 522 scattered by the structure; and a step 516 of determining the measurement from the radiation 522 scattered by the structure.

The measurement time period comprises a plurality of successive time portions and the radiation 132 used for at least two of the plurality of successive time portions is received from a different one of a plurality of beam-modifying modules 120a-120n, a size and/or shape of the radiation beam 132 in a pupil plane being different for each of the plurality of beam-modifying modules 120a-120n.

The method 500 shown in Figure 17 may be carried out using the apparatus shown in Figure 8. It will be appreciated that the method shown in Figure 17 may comprise any corresponding features of the apparatus shown in Figure 8.

The method shown in Figure 17 may be combined with the method shown in Figure 16.

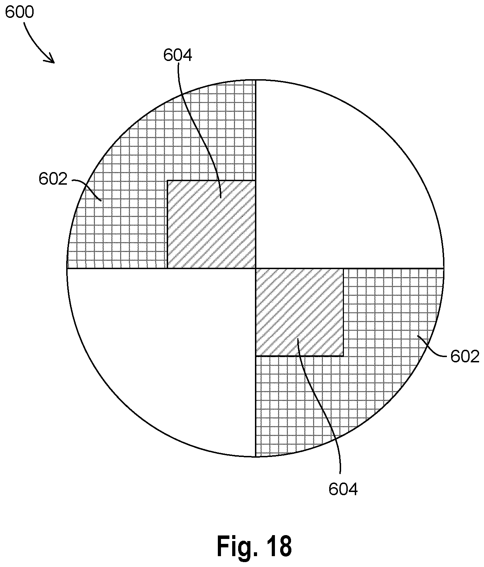

Figure 18 shows an example of a pupil plane 600 of a metrology tool during the at least one measurement 510 of the method 500 shown in Figure 17. For a first time portion, the radiation 132 is received from a first one of a plurality of beam-modifying modules 120a which illuminates a first portion 602 of the pupil plane 600. For a second time portion, the radiation 132 is received from a second one of a plurality of beam-modifying modules 120b which illuminates a second portion 604 of the pupil plane 600.

The method 500 shown in Figure 17 effectively allows for an illumination mode which is a weighted average of the two illumination modes 602, 604, the weights being the lengths of the first and second time portions.

Further embodiments are disclosed in the subsequent list of numbered clauses:
1. An apparatus for use in a metrology apparatus, the apparatus comprising:
   selection optics; and
   a plurality of beam-modifying modules;
   wherein the selection optics is arranged to receive an input radiation beam and is configurable so as direct the radiation beam to any one of the plurality of beam-modifying modules; and
   wherein each of the plurality of beam-modifying modules is arranged to control the same at least one attribute of the radiation beam.
2. The apparatus of clause 1 wherein the selection optics is configurable in a finite number of discrete configurations, each such discrete configuration corresponding to a different one of the beam-modifying modules.
3. The apparatus of clause 1 or clause 2 wherein the selection optics comprises one or more optical elements that are configurable in a plurality of different configurations.
4. The apparatus of any preceding clause wherein the selection optics comprises one or more movable optical elements.
5. The apparatus of clause 4 wherein at least one of the one or more movable optical elements comprises a reflective optical element.
6. The apparatus of any preceding clause wherein the selection optics is arranged to receive secondary radiation output by any one of the plurality of beam-modifying modules and is configurable so as direct the secondary radiation received from any one of the plurality of beam-modifying modules to a common output.
7. The apparatus of any preceding clause wherein the selection optics comprises:
   input optics disposed optically upstream of the plurality of beam-modifying modules, a configuration of which determines which of the plurality of beam-modifying modules the radiation beam is directed to; and
   output optics disposed optically downstream of the beam-modifying modules, a configuration of which determines where secondary radiation output by one of the plurality of beam-modifying modules is directed to.
8. The apparatus of clause 7 wherein the input optics and the output optics share a common support.
9. The apparatus of clause 7 or clause 8 wherein the input optics and the output optics share a movement mechanism.
10. The apparatus of any preceding clause further comprising focusing optics arranged to focus the radiation beam in the vicinity of one or more configurable or movable optical elements of the selection optics.
11. The apparatus of clause 10 further comprising focusing optics downstream of each configurable or movable optical element of the selection optics that is arranged to decrease a divergence of the radiation.
12. The apparatus of any preceding clause wherein a timescale for switching between two configurations of the selection optics is of the order of 2 ms or less.
13. The apparatus of any preceding clause further comprising a controller operable to control the selection optics; and/or the plurality of beam-modifying modules.
14. The apparatus of any preceding clause wherein each of the plurality of beam-modifying modules is configurable in any one of a plurality of different configurations, wherein the at least one attribute of the radiation beam is different for each of the plurality of different configurations.
15. The apparatus of clause 14 wherein a timescale for switching between two configurations of any one of the beam-modifying modules is larger than a timescale for switching between two configurations of the selection optics.
16. The apparatus of clause 14 or clause 15 wherein a timescale for switching between two configurations of any one of the beam-modifying module is of the order of 5 ms or more.
17. The apparatus of any preceding clause wherein each of the plurality of beam-modifying modules is arranged to control a spectrum of the radiation beam.
18. The apparatus of any preceding clause wherein each of the plurality of beam-modifying modules is arranged to control a polarization state of the radiation beam.
19. The apparatus of any preceding clause wherein each of the plurality of beam-modifying modules is arranged to control a size and/or shape of the radiation beam.
20. A metrology tool for determining one or more parameters of interest of a structure on an object, the metrology tool comprising the apparatus according to any preceding clause.
21. The metrology tool of clause 20 further comprising:
   projection optics arranged to project radiation output by the apparatus according to any one of clauses 1 to 19 onto a beam spot region in which the structure is positionable;
   detection optics arranged to receive at least a portion of radiation scattered by the structure; and
   a detector operable to determine one or more parameters from the received scattered radiation.
22. The metrology tool of clause 20 or clause 21 wherein each of the plurality of beam-modifying modules is arranged to control a size and/or shape of the radiation beam in a field plane of the metrology tool.
23. The metrology tool of clause 20 or clause 21 wherein each of the plurality of beam-modifying modules is arranged to control a size and/or shape of the radiation beam in a pupil plane of the metrology tool.
24. The metrology tool of any one of clauses 20 to 23 further comprising a radiation source operable to produce the radiation that is received by the apparatus.
25. The metrology tool of any one of clauses 20 to 24 further comprising a support for supporting an object such that it is positionable so as to receive radiation from the apparatus according to any one of clauses 1 to 19.
26. The metrology tool of clause 25 further comprising a movement mechanism operable to cause relative movement of the support and the apparatus according to any one of clauses 1 to 19.
27. A metrology method for determining one or more parameters of interest of a structure on an object, the metrology method comprising:
   making a plurality of successive measurements by:
      projecting radiation onto the structure;
      receiving at least a portion of the radiation scattered by the structure; and
      determining the measurement from the radiation scattered by the structure; wherein each of the plurality of successive measurements is made using radiation with different characteristics; and
   wherein the radiation used for at least two of the plurality of successive measurements is received from a different one of a plurality of beam-modifying modules, each of the plurality of beam-modifying modules being arranged to control the same at least one attribute of the radiation beam.
28. The metrology method of clause 27 further comprising: re-configuring a second one of the plurality of beam-modifying modules while one of the plurality of successive measurements is being made using a first one of the plurality of beam-modifying modules.
29. A metrology method for determining one or more parameters of interest of a structure on an object, the metrology method comprising:
   making at least one measurement during a measurement time period by:
   projecting radiation onto the structure;
   receiving at least a portion of the radiation scattered by the structure; and
   determining the measurement from the radiation scattered by the structure;
wherein the measurement time period comprises a plurality of successive time portions and wherein the radiation used for at least two of the plurality of successive time portions is received from a different one of a plurality of beam-modifying modules, a size and/or shape of the radiation beam in a pupil plane being different for each of the plurality of beam-modifying modules.

Although specific reference is made to "metrology apparatus / tool / system" or "inspection apparatus / tool / system", these terms may refer to the same or similar types of tools, apparatuses or systems. For example, the inspection or metrology apparatus that comprises an embodiment of the invention may be used to determine characteristics of structures on a substrate or on a wafer. For example, the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An apparatus for use in a metrology apparatus, the apparatus comprising:
selection optics; and
a plurality of beam-modifying modules;
wherein the selection optics is arranged to receive an input radiation beam and is configurable so as direct the radiation beam to any one of the plurality of beam-modifying modules; and
wherein each of the plurality of beam-modifying modules is arranged to control the same at least one attribute of the radiation beam.

2. The apparatus of claim 1 wherein the selection optics is configurable in a finite number of discrete configurations, each such discrete configuration corresponding to a different one of the beam-modifying modules.

3. The apparatus of claim 1 or claim 2 wherein the selection optics comprises one or more optical elements that are configurable in a plurality of different configurations.

4. The apparatus of any preceding claim wherein the selection optics comprises one or more movable optical elements.

5. The apparatus of any preceding claim wherein the selection optics is arranged to receive secondary radiation output by any one of the plurality of beam-modifying modules and is configurable so as direct the secondary radiation received from any one of the plurality of beam-modifying modules to a common output.

6. The apparatus of any preceding claim wherein the selection optics comprises:
input optics disposed optically upstream of the plurality of beam-modifying modules, a configuration of which determines which of the plurality of beam-modifying modules the radiation beam is directed to; and
output optics disposed optically downstream of the beam-modifying modules, a configuration of which determines where secondary radiation output by one of the plurality of beam-modifying modules is directed to.

7. The apparatus of any preceding claim further comprising focusing optics arranged to focus the radiation beam in the vicinity of one or more configurable or movable optical elements of the selection optics.

8. The apparatus of claim 7 further comprising focusing optics downstream of each configurable or movable optical element of the selection optics that is arranged to decrease a divergence of the radiation.

9. The apparatus of any preceding claim wherein a timescale for switching between two configurations of the selection optics is of the order of 2 ms or less.

10. The apparatus of any preceding claim wherein each of the plurality of beam-modifying modules is configurable in any one of a plurality of different configurations, wherein the at least one attribute of the radiation beam is different for each of the plurality of different configurations.

11. The apparatus of claim 10 wherein a timescale for switching between two configurations of any one of the beam-modifying modules is larger than a timescale for switching between two configurations of the selection optics.

12. The apparatus of any preceding claim wherein each of the plurality of beam-modifying modules is arranged to control a spectrum of the radiation beam.

13. The apparatus of any preceding claim wherein each of the plurality of beam-modifying modules is arranged to control a size and/or shape of the radiation beam.

14. A metrology tool for determining one or more parameters of interest of a structure on an object, the metrology tool comprising the apparatus according to any preceding claim.

15. A metrology method for determining one or more parameters of interest of a structure on an object, the metrology method comprising:
making a plurality of successive measurements by:
projecting radiation onto the structure;
receiving at least a portion of the radiation scattered by the structure; and
determining the measurement from the radiation scattered by the structure; wherein each of the plurality of successive measurements is made using radiation with different characteristics; and
wherein the radiation used for at least two of the plurality of successive measurements is received from a different one of a plurality of beam-modifying modules, each of the plurality of beam-modifying modules being arranged to control the same at least one attribute of the radiation beam.
